# EUROPEAN PATENT SPECIFICATION

(11) **EP 0 880 172 B1**
(45) Date of publication and mention of the grant of the patent: **17.01.2007**
(21) Application number: 98109356.0
(22) Date of filing: 22.05.1998
(51) Int. Cl.: H01L 21/66, G01R 31/27, G01R 31/30, G01R 31/3185, H01L 27/02

(54) **Semiconductor integrated circuit with test mode and normal-mode operation current paths**
Integrierte Halbleiterschaltung mit Testmode- und Normalbetriebsstrompfaden
Circuit intégré semiconducteur avec trajets de courant en mode d'essai et en mode normal d'opération

(30) Priority: 23.05.1997 JP 13336997
(43) Date of publication of application: 25.11.1998
(73) Proprietor: MATSUSHITA ELECTRIC INDUSTRIAL CO., LTD., Kadoma-shi, Osaka 571-8501 (JP)
(72) Inventor: Nishimura, Kazuko, Uji-shi, Kyoto, 611-0013 (JP); Akamatsu, Hironori, Hirakata-shi, Osaka, 573-1105 (JP); Matsuzawa, Akira, Yawata-shi, Kyoto, 614-8068 (JP)
(74) Representative: Grünecker, Kinkeldey, Stockmair & Schwanhäusser Anwaltssozietät

(56) References cited:
- EP-A- 0 283 186
- EP-A- 0 811 850
- US-A- 5 025 344
- US-A- 5 644 251

## Description

### BACKGROUND OF THE INVENTION

The invention relates to semiconductor integrated circuits that have a circuit for use in self-testing and self-fault-restoring.

In a CMOS integrated circuit constructed of a PMOS circuit and an NMOS circuit, only one of them is placed in the ON state when the CMOS integrated circuit is in operation, and therefore the dissipation of power is low. When faults and/or defects, such as bridging between wires, occur in CMOS integrated circuits, power consumption is increased on the order of a few digits. This is utilized in methods, such as standby current testing and IDDQ testing, for detecting faults by observing increases in the value of electric current at the time of testing LSIs formed of CMOS integrated circuits.

With the reduction in LSI supply voltage with a view to reducing power consumption as low as possible, the reduction of Vt (threshold voltage) for MOS transistors disposed in CMOS integrated circuits has been strongly demanded in order to secure a satisfactory operating speed. However, for the case of MOS transistors low in Vt, there occurs an increase in leakage current in the standby state. To cope with such a problem, two techniques have been developed for the reduction of power consumption during the standby period. One technique employs a configuration for CMOS integrated circuits for increasing the Vt of respective MOS transistors in the standby state by wafer voltage control, i.e., a so-called variable threshold-voltage CMOS integrated circuits (VT-CMOSs) configuration. On the other hand, the other technique employs the foregoing MT-CMOS integrated circuit configuration for CMOS integrated circuits, in other words a CMOS integrated circuit configuration is provided in which a circuit of low-Vt MOS transistors is placed in the OFF state during the standby period using high-Vt MOS transistors. The MT-CMOS integrated circuit configuration has the advantage over the VT-CMOS integrated circuit configuration in that it can achieve faster switching from operation mode to standby mode.

The above-described MT-CMOS integrated circuit configuration however has the problem that the amount of leakage current occurring in standby mode increases due to each of low-Vt MOS transistors forming a CMOS integrated circuit. The proportion of an incremental amount of abnormal current accompanied with abnormal conditions (faults and/or defects) is therefore reduced, which makes it difficult to detect faults at test time. Testing including IDDQ testing is difficult to carry out.

Document EP-A-0 283186 relates to a chip recovery circuit which is formed on an semiconductor integrated circuit provided with a plurality of functionally equivalent circuit blocks. The recovery circuit makes chip recovery possible by deactivating any circuit block in which abnormal operating characteristics are detected. The remaining circuit blocks may then be used. A switch means corresponds to each circuit block for coupling power from the power line to the corresponding circuit block. A switch control means corresponds to each switch means for selectively controlling the activation of the corresponding switch means.

### SUMMARY OF THE INVENTION

Bearing in mind the above-described problems with the prior art techniques, the invention was made. Accordingly, an object of the invention is to provide a novel semiconductor integrated circuit containing therein MOS circuits constructed of low-Vt transistors, the semiconductor integrated circuit being capable of detecting an increase in the amount of electric current caused by an abnormal condition taking place in a MOS circuit.

This is achieved by the features as set forth in the independent claim. Further advantageous embodiments of the present invention are set forth in the dependent claims.

A circuit of low-Vt MOS transistors that is tested is divided into a plurality of circuit blocks and high-Vt MOS transistors for turning off the circuit blocks during the normal standby mode of operation are utilized also at the time of testing for leakage current. In other words, it is arranged for each circuit block that a circuit current in each circuit block is directed to a test circuit through a high-Vt MOS transistor.

A circuit block that is tested is selected using a high-Vt MOS transistor disposed for switching off power at standby time, and a supply current in a circuit of low-Vt MOS transistors is detected for each selected circuit block, and the detected supply current is compared with a reference value to determine whether it is acceptable or not. As a result of such arrangement, the number of circuit blocks that are tested at one time during the test mode of operation is limited, whereupon testing including IDDQ testing can be implemented by detecting an increase in the supply current due to faults and/or defects in low-Vt MOS transistors.

A circuit block is tested to determine presence or absence of a fault therein by leakage current testing, and if the circuit block is faulty, then such a faulty circuit block is replaced by a previously-prepared spare circuit block.

As a result of such arrangement of replacing a faulty circuit block with a spare circuit block, it becomes possible to correct existing faults. This provides improvements in the yield of semiconductor integrated circuits. Additionally, since leakage current is judged per circuit block, this makes it possible to easily specify a circuit block in which a leakage current in excess of the reference value flows. This invention provides a semiconductor integrated circuit capable of circuit block evaluation, fault analysis, and other similar operations.

### BRIEF DESCRIPTION OF THE DRAWINGS

FIGURE **1** shows in block form a semiconductor integrated circuit belonging to the invention.
FIGURE **2** is a circuit diagram showing the details of a test-target circuit, i.e., a candidate for testing, and a circuit block switch part shown in FIGURE **1**.
FIGURE **3** is a circuit diagram showing the details of a test circuit shown in FIGURE **1**.
FIGURE **4** is a circuit diagram of a circuit where a reference current value is determined based on measured values.
FIGURE **5** is a circuit diagram partially showing a circuit formed as a result of addition of a spare block switch circuit to the FIG. **2** circuit.

### PREFERRED EMBODIMENT OF THE INVENTION

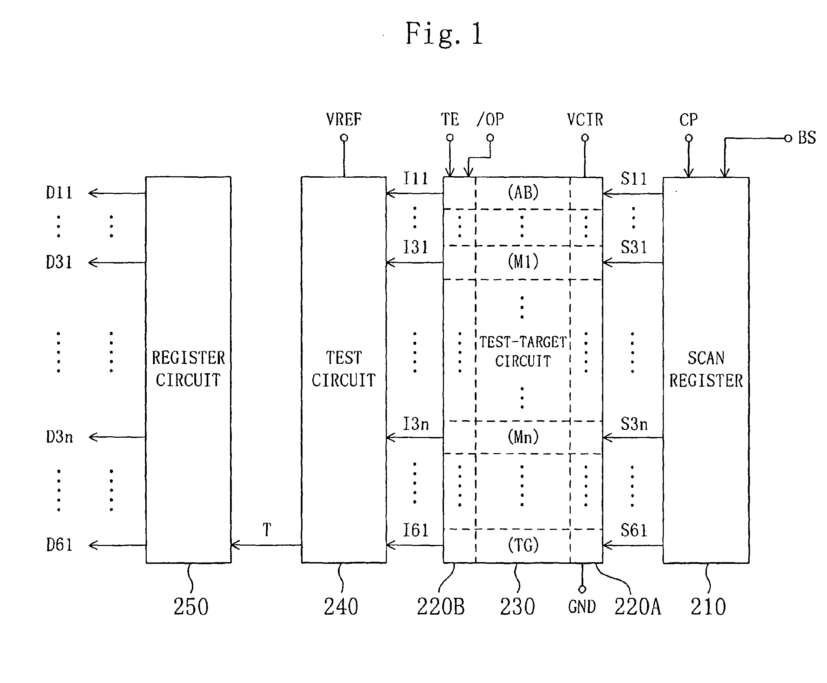

A semiconductor integrated circuit of the invention is described by reference to the accompanying drawings. Referring first to FIGURE **1**, therein shown is an exemplary structure of a semiconductor integrated circuit (SIC) of the invention. **210** is a scan register. The scan register **210** is circuit block selection means operable to receive block selection data **BS** and to sequentially transfer the received data **BS** according to a clock **CP** to provide respective block selection signals **S11-S61. 220A** and **220B** are circuit block switch parts. The circuit block switch parts **220A** and **220B** are circuit block switch means for (a) applying a circuit voltage **VCIR** to a test-target circuit **230** as a target for testing constructed of circuit blocks including a circuit block **AB** and a circuit block **TG** and (b) switching the paths of circuit currents flowing in the circuit blocks between the paths of detected currents **I11-I61** and a path to ground (**GND**) in response to the test enable signal **TE**, the block selection signals **S11-S61**, and the operation selection signal **/OP** ("/" is indicative of a signal of negative logic). The test-target circuit **230** may comprise SRAMs, ROMs, and logical circuits formed on the same chip. The test-target circuit **230** is a circuit divisible into a plurality of circuit blocks, i.e., the foregoing circuit blocks **AB-TG. 240** is a test circuit. The test circuit **240** is test means for cutting off the paths of each detected current **I11-I61** during the normal mode of operation, for generating a reference current on the basis of a reference voltage **VREF** received, for making a comparison between a detected current received and the reference current generated, and for providing a block test result **T** when a specified condition is met. **250** is a register circuit. The register circuit **250** is storage means for receiving the block test result **T** and sequentially shifting the block test result **T** to generate parallel block test data **D11-D61**, and for providing the test data **D** as required, for example, when it is required to specify a faulty circuit block.

The operation of the FIG. 1 SIC is now described below. The scan register **210** sequentially transfer the block selection data **BS** composed of a string of bits such as [HIGH LOW LOW LOW LOW, .....] of which a bit in the MSB position is the only one HIGH bit, and sequentially places one of the block select signals **S11-S61** in the state of HIGH for forwarding to the circuit block switch parts **220A** and **220B** according to the clock **CP**. Upon the receipt of the test enable signal **TE** at the level of HIGH, the circuit block switch parts **220A** and **220B** switch the paths of the circuit currents in the circuit blocks **AB-TG.** More specifically, the switch parts **220A** and **220B** supply to the test circuit **240** a detected current **I** corresponding to a circuit block that receives a block selection signal **S** at HIGH (for example, if the signal **S11** is HIGH, then the detected current **I11** is supplied to the circuit **240**). On the other hand, upon the receipt of the test enable signal **TE** at the level of LOW, all of the circuit currents **I11-I61** in the test-target circuit **230** are supplied to the test circuit **240** when the operation selection signal **/OP** is HIGH. When the operation selection signal **/OP** is LOW, all of the circuit currents **I11-I61** flow out of the circuit **230** to ground (**GND**). During the test mode of operation of a certain circuit block, the test circuit **240** prepares, based on the received reference voltage **VREF**, a reference current as a reference value and provides the block test result **T** indicating that the circuit block fails to operate normally when a detected current as to the circuit block exceeds the value of the reference current. Additionally, during the normal mode of operation, the paths of the circuit (detected) currents are placed in the cutoff state. The register circuit **250** receives and sequentially shifts the result **T** to generate the block test data **D11-D61** indicating which of the circuit blocks fails to operate normally. The register circuit **250** provides the block test data **D11-D61** as required. The above-described operation makes it possible to examine either a circuit current flowing in a circuit block selected from among all the circuit blocks **AB-TG** or a plurality of circuit currents flowing in a plurality of circuit blocks selected from among all the circuit blocks **AB-TG.**

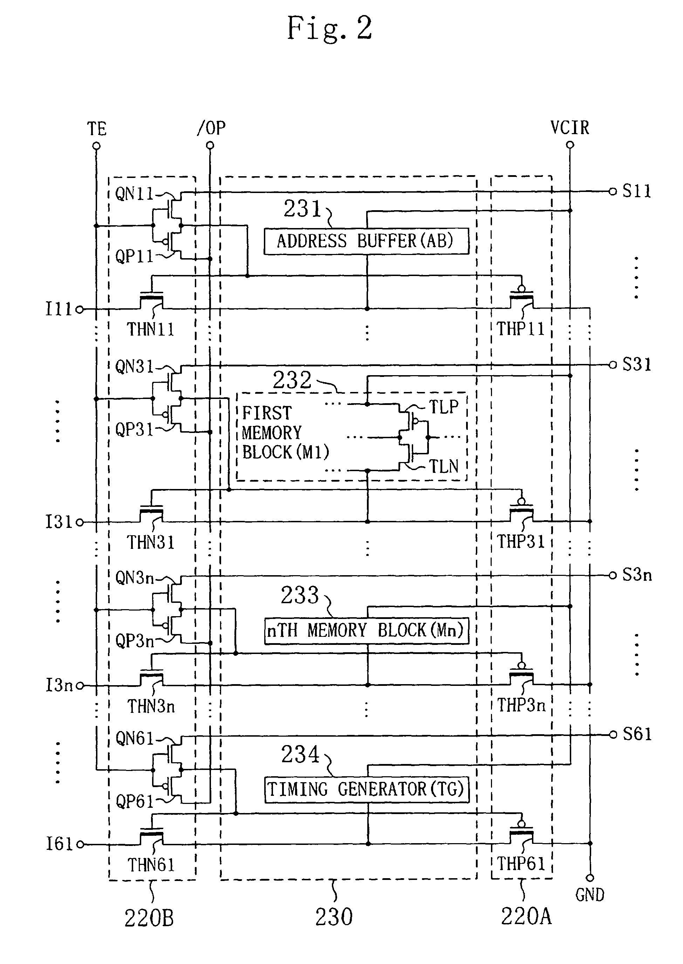

FIGURE **2** shows the test-target circuit **230** and the circuit block switch parts **220A** and **220B** in FIGURE **1**. The test-target circuit **230** is constructed of circuit blocks including an address buffer **231**, first through nth memory blocks **232-233** and a timing generator **234.** The circuit voltage **VCIR** is applied to each of these circuit blocks. Each circuit block is provided with a current path through which its circuit current is discharged to **GND** during the normal mode of operation, and another current path into which its circuit current as a detected current **I** is discharged during the test mode of operation. Each circuit block is a CMOS integrated circuit constructed of a low-Vt NMOS and a low-Vt PMOS transistor **TLN** and **TLP.** High-Vt PMOS transistors **THP11-THP61** together form the circuit block switch part **220A.** Each high-Vt PMOS transistor **THP11-THP61** acts as a power supply line switch means capable of cutting off a respective current path (i.e., a respective normal mode operation current path) to **GND.** On the other hand, each high-Vt NMOS transistor **THN11-THN61** acts as a power supply line switch means capable of cutting off a respective current path (i.e., a respective test mode operation current path) to the test circuit **240.** Low-Vt NMOS transistors **QN11-QN61** and low-Vt PMOS transistor **QP11-QP61** are drive devices for the switching of the high-Vt MOS transistors and form, together with the high-Vt NMOS transistors **THN11-THN61,** the circuit block switch part **220B.**

The operation of the circuit block switch part **220A** and the operation of the circuit block switch part **220B** are described in different situations. In the first situation, the test enable signal **TE** is HIGH. In this case, all the low-Vt NMOS transistors **QN11-QN61** turn on and, at the same time, all the low-Vt PMOS transistors **QP11-QP61** turn off. As a result, the block selection signals **S11-S61** are supplied to the gates of the high-Vt MOS transistors in the circuit blocks, wherein a circuit block that has received a block selection signal **S** at HIGH is selected. In such a selected circuit block, its high-Vt NMOS and PMOS transistors **THN** and **THP** are placed in the ON state and in the OFF respectively. Because of this, the selected circuit block is connected to its test mode operation current path while it is cut off from its normal mode operation current path. A circuit current in the selected circuit block becomes a corresponding detected current **I** which is then supplied through the test mode operation current path to the test circuit **240.** At this time, circuit currents in the remaining other circuit blocks that have received block selection signals **S** at LOW are discharged to ground (**GND**) and these circuit blocks therefore have no effect on testing.

On the other hand, when the test enable signal **TE** is LOW, all the low-Vt NMOS transistor **QN11-QN61** turn off and, at the same time, the all the low-Vt PMOS transistors **QP11-QP61** turn on. As a result, the operation selection signal **/OP** is supplied to the gates of the high-Vt MOS transistors. In the second situation, SIGNAL **TE** is LOW and SIGNAL **/OP** is HIGH. In this case, all the high-Vt NMOS transistors **THN11-THN61** turn on and, at the same time, all the high-Vt PMOS transistors **THP11-THP61** turn off. As a result, all of the circuit blocks are connected to their respective test mode operation current paths and are cut off from their respective normal mode operation current paths. Accordingly, the detected currents **I11-I61,** i.e., the circuit currents of all of the circuit blocks, are supplied by way of the test mode operation current paths to the test circuit **240.** These current paths are cut off separately at their respective supply destination and the overall circuit current in the test-target circuit **230,** i.e., the amount of current consumed in the test-target circuit **230,** becomes zero. In the third situation, SIGNAL **TE** is LOW and SIGNAL **/OP** is LOW. In this case, all the high-Vt NMOS transistors **THN11-THN61** turn off and, at the same time, all the high-Vt PMOS transistors **THP11-THP61** turn on. As a result, all the circuit blocks are connected to the normal mode operation current paths and are cut off from the test mode operation current paths, and all the circuit currents are discharged to ground thereby permitting normal-mode operations. The first situation's signal combination is used for test mode operations. The second situation's signal combination is used for normal standby mode operations. The third situation's signal combination is used for normal mode operations.

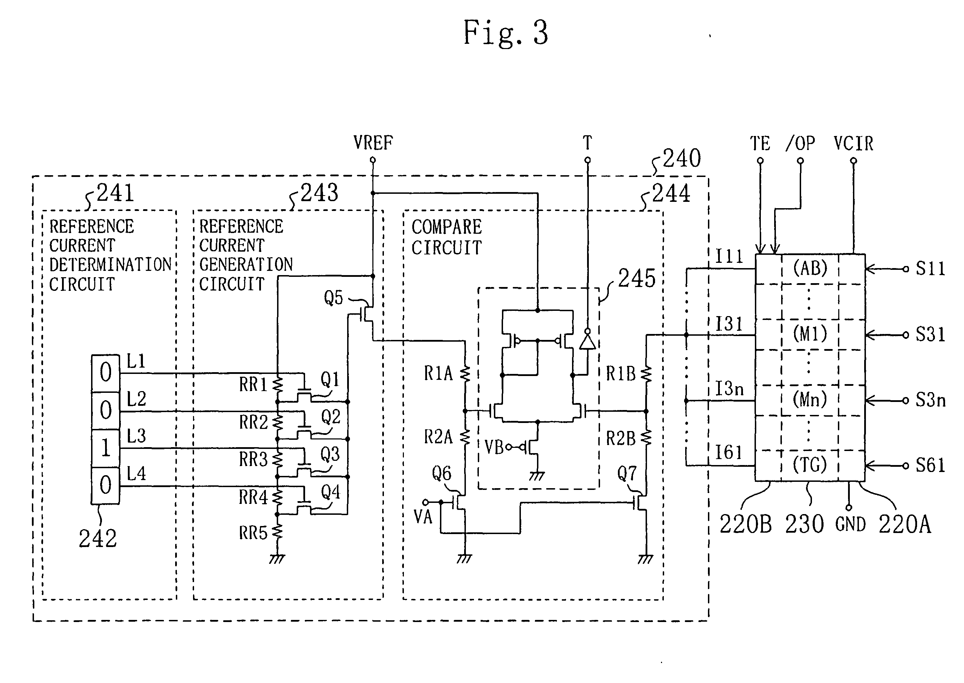

FIGURE **3** is a circuit diagram of the test circuit **240** shown in FIGURE **1.** A reference current determination circuit **241** is a signal supply means for supplying current designation signals **L1-L4** on the basis of parallel data of bits in which the number of logical 1 bits is one (in other words, the remaining other bits are all logical 0 bits), to determine a reference current value. The circuit **241** is formed of a reference current determination memory **242** for storing the parallel data. **243** is a reference current generation circuit. The circuit **243** is a reference value generation means for determining a reference current from the received reference voltage **VREF** on the basis of the signals **L1-L4.** The circuit **243** provides the reference current thus determined. **244** is a compare circuit. The compare circuit **244** is a comparison means. The compare circuit **244** cuts off the paths of the detected currents during the normal mode of operation, while on the other hand during the test mode of operation the circuit **244** receives a detected current and a reference current to make a comparison therebetween, and provides the block test result **T** at HIGH when the detected current exceeds the reference current. The reference current generation circuit **243** is formed of reference current determination resistors **RR1-RR5** and MOS transistors **Q1-Q5.** The compare circuit **244** is formed of voltage division resistors **R1A, R2A, R1B, R2B,** MOS transistors **Q6** and **Q7,** and a comparator **245.** The resistors **R1A** and **R1B** have the same resistance. The resistors **R2A** and **R2B** have the same resistance. A bias voltage **VA** is used to adjust the value of current flowing in each MOS transistor **Q6** and **Q7** and to turn off both the MOS transistors **Q6** and **Q7** during the normal mode of operation. On the other hand, a bias voltage **VB** is used to adjust the value of current flowing in the comparator **245** and to turn off the comparator **245** during the normal mode of operation.

The operation of the test circuit **240** is described. The test circuit **240** is fed the reference voltage **VREF** as a power supply voltage only during the test mode of operation to operate. Since in normal mode operation **VREF** is not applied to the test circuit **240** and all of the MOS transistors **Q6** and **Q7** and the comparator **245** are placed in the OFF state, the paths of the detected currents **I11-I61** are cut off from the test-target circuit **230.** As a result, the overall circuit current in the test-target circuit **230,** i.e., the amount of current consumed in the circuit **230,** becomes zero during the normal standby mode of operation. On the other hand, during the test mode of operation, the standard supply voltage (**Vdd**) of the test-target circuit **230** is applied as **VREF** to the test circuit **240** and is also applied as **VCIR** to the test-target circuit **230.** The reference current determination circuit **241** supplies, based on the parallel data of four bits stored in the memory **242,** the signals **L1-L4** of which the signal **L3** is HIGH. The signal **L3** at HIGH causes its corresponding MOS transistor **Q3** to turn on to divide **VREF** by use of a combination of the resistors **RR1-RR5** and the resulting voltage is applied to the gate of the MOS transistor **Q5.** According to the gate voltage received, the MOS transistor **Q5** amplifies a current supplied by **VREF** for forwarding to the compare circuit **244.** The compare circuit **244** applies to one input terminal of the comparator **245** a set voltage produced by the amplified current and the resistors **R1A** and **R2A** and applies to the second input terminal of the comparator **245** a detected voltage produced by the received detected current and the resistors **R1B** and **R2B.** The comparator **245** makes a comparison between the set voltage and the detected voltage applied at its respective input terminals and provides the block test result **T** at HIGH when the detected voltage is greater than the set voltage. Comparison of a detected voltage and a set voltage makes it possible to compare a detected current and a reference current. Additionally, by supplying **Vdd** as **VREF** and by adequately determining **VCIR** that is supplied to the test-target circuit **230**, it becomes possible to facilitate acceleration testing by application of an excessive voltage as **VCIR.** In this case, in order to achieve external application of **VCIR** and **VREF** from outside the semiconductor integrated circuit during the test mode of operation, terminals for these voltages may be provided on the semiconductor integrated circuit.

In the foregoing description, the circuit **243** generates reference currents of four different values on the basis of four different voltages obtained by voltage division of **VREF.** The number of levels of voltage produced by voltage division of **VREF** may be increased using the following structure for further division of the reference current value.

For example, an arrangement may be made in which there are provided three reference current determination memories **242.** The number of data items is increased up to 12, with four data items stored in each memory **242.** The number of combinations of the resistors **RR1-RR4** and the MOS transistors **Q1-Q4** is increased to 12. As a result, each data item is assigned a respective combination of a resistor **RR** and a MOS transistor **Q.** Here, to determine a reference current at crude accuracy, (i) the resistance of each of a first group of four resistors **RR1-RR4** is set in order that voltage division by these resistors **RR1-RR4** may be carried out in a wide voltage range, (ii) the resistance of each of a second group of four resistors **RR1-RR4** is set in order that voltage division by these resistors **RR1-RR4** may be carried out in a medium voltage range, and (iii) the resistance of each of a third group of four resistors **RR1-RR4** is set in order that voltage division by these resistors **RR1-RR4** may be carried out in a narrow voltage range. In other words, these three register groups function as a low accuracy resistor group, as a medium accuracy resistor group, and as a high accuracy resistor group, respectively. Likewise, the twelve data items in the memories **242** are supplied to their corresponding MOS transistors as low accuracy data, as medium accuracy data, and high accuracy data, respectively. As a result, the twelve MOS transistors are placed either in the ON state or in the OFF state based on the 12-bit data read out of the memories **242.** Accordingly, resistors of the three resistor groups selected by the corresponding MOS transistors and the resistor **RR5** are connected in series and **VREF** is voltage-divided by the these resistors in series connection. In this way, a voltage resulting from voltage division of **VREF,** i.e., a voltage able to be highly accurate, is applied to the gate of the MOS transistor **Q5** thereby allowing a reference current to take a further divided fine value. If it is judged from characteristics of a test-target circuit and from required accuracy that testing at crude accuracy is sufficient, then only the four low accuracy resistors are used to obtain a reference current. On the other hand, if high-accuracy testing is required, then all of the low, medium, and high accuracy resistor groups are used to obtain a reference current. Testing is carried out based on the obtained reference current. Being compared in value with such an obtained reference current, each of the detected currents **I11-I61** is judged by the compare circuit **244.**

The aspect of the above-described structure is to provide semiconductor integrated circuits capable of being tested quickly when testing may be carried out at low accuracy because only the four low accuracy resistors are involved and also capable of being tested at high accuracy as required.

The number of reference current determination memories **242** each capable of storage of four bits is three, which allows one reference current to assume twelve different values. However, the number of reference current determination memories is not limited to three and the number of bits that each memory is designed to store is not limited to four.

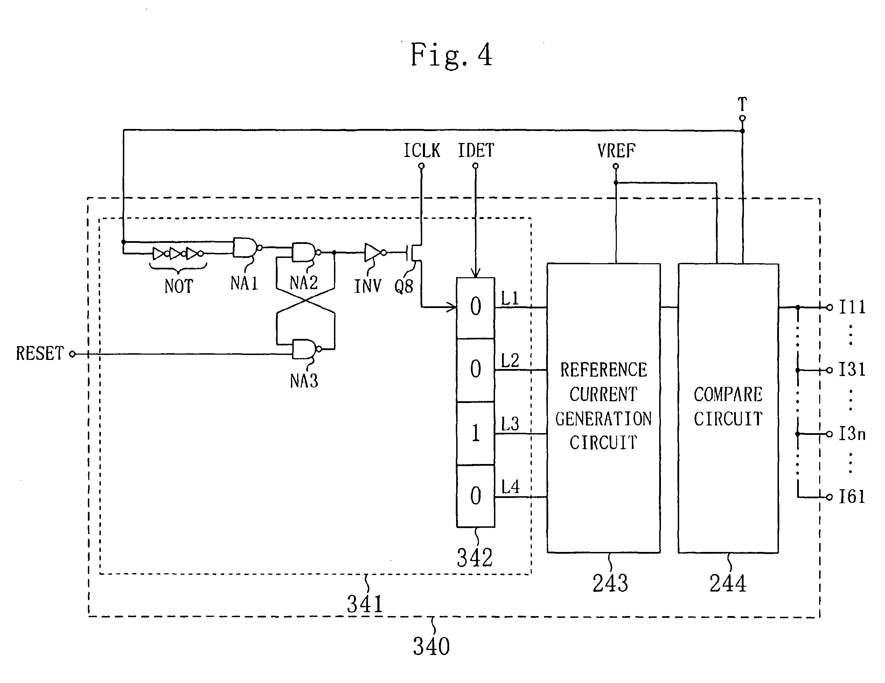

As describe above, reference currents are determined by input values to the reference current determination memory **242.** Referring now to FIGURES **3** and **4,** as a modified version of the reference current determination technique a reference current determination structure on the basis of an actually measured leakage current value is now described below.

FIGURE **4** is a circuit diagram of a circuit for use in determining a reference current value based on a measured leakage current value. In the following description the same elements as shown in FIGURE **3** have been indicated by like reference numerals and the description thereof is not made.

A test circuit **340** of FIGURE **4** results from addition of a structure for sequentially increasing the value of reference current, to the test circuit **240** of FIGURE **3.** A reference current determination circuit **341** is a signal supply means for providing the current designation signals **L1-L4** on the basis of parallel data composed of bits in which the number of logical 1 bits is only one (in other words, all the remaining other bits are logical 0 bits), to determine a current reference value. The circuit **341** is constructed of an inverting circuit **NOT** of three inverters, an inverter **INV,** NAND circuits **NA1-NA3,** an NMOS transistor **Q8**, and a reference current determination memory **342.** The memory **342** is a storage means for storing bits that are all at logical 0 at the start of operation of the circuit **341.** With the operation of the circuit **341,** the memory **342** acts as a shift register and generates and stores parallel data. A current determination clock **ICLK,** which is applied through the NMOS transistor **Q8** to the memory **342,** is a clock for allowing the memory **342** to perform sequential shift operation. A reference current determination signal **IDET,** which is applied to the memory **342,** is a signal composed of a string of bits of which a bit in the MSB position is the only one HIGH bit (that is, all the remaining other bits are LOW). **RESET** indicates a reset signal, and the LOW state of the signal **RESET** at the time when the clock **ICLK** is not supplied to the memory **342** starts a supply of the clock **ICLK** to the memory **342.**

The operation of the reference current determination circuit **341** is described. A reference circuit block is preselected which is the circuit block that is estimated, when viewed in the light of circuit configuration, to be most likely to undergo the occurrence of leakage current and a leakage current that flows in the reference circuit block is measured. A circuit current flowing in the reference circuit block as the test-target circuit **230** is supplied by the circuit block switch parts **220A** and **220B** of FIGURE **3** to the compare circuit **244** via a test mode operation current path. The compare circuit **244** compares the circuit current as a detected current **I** and a reference current, and provides the block test result **T** at HIGH when the detected current exceeds the reference current.

As the signal **IDET** of FIGURE **4**, a serial signal [HIGH LOW LOW LOW ..., LOW] is sequentially supplied according to CLOCK **ICLK,** on the basis of current determination data [1 0 0 0 ... 0] of a string of bits of which a bit in the MSB position is the only one logical 1 bit and all the remaining other bits are logical 0 bits. As the signal **RESET,** a LOW is supplied only at the start of the operation of the circuit **341,** and in the other situations a HIGH is supplied. In other words, at the operation start of the circuit **341** the signal **RESET** is LOW, so that the output of the NAND circuit **NA3,** i.e., one input of the NAND circuit **NA2,** is fixed at HIGH.

A situation, in which the block test result **T** is LOW, i.e., a situation in which a detected current from the reference circuit block falls below the reference current, is considered. In such a case, since the result **T** is supplied to one input of the NAND circuit **NA1** and a signal which is an inversion of the result **T** is supplied to the second input of the NAND circuit **NA1,** the output of the NAND circuit **NA1** as the second input of the NAND circuit **NA2** is HIGH, regardless of the result **T.** Since all of the inputs of the NAND circuit **NA2** are HIGH, the output of the NAND circuit **NA2** is therefore LOW. The inverter **INV** provides a HIGH as its output, which turns on the NMOS transistor **Q8.** The clock **ICLK** is then applied to the memory **342.** In the memory **342,** the signal **IDET** is sequentially shifted according to the clock **ICLK.**

Next, a situation, in which a HIGH of the signal **IDET** on the basis of the MSB of logical 1 of current determination data is sequentially shifted resulting in the block test result **T** becoming HIGH, is considered, in other words, a situation, in which a detected current exceeds the reference current, is considered. In this case, the block test result **T** at HIGH is supplied to the one input of the NAND circuit **NA1** and, thereafter, the block test result **T,** which has been delayed and inverted by the inversion circuit **NOT** from HIGH to LOW, is supplied to the second input of the NAND circuit **NA1.** In other words, only for a short period of time from the time when the result **T** is supplied to the one input of the NAND circuit **NA1** until the time when the delayed, inverted result **T** is supplied to the second input of the NAND circuit **NA1,** both the inputs of the NAND circuit **NA1** are fed HIGHs respectively. As a result, only for a short period of time, the circuit **NA1** supplies a LOW, as its output, to one input of the NAND circuit **NA2.** In this case, the NAND circuit **NA2** supplies a HIGH as its output, regardless of the level of signals received from the NAND circuit **NA3.** Because of this, the output of the inverter **INV** is LOW and the NMOS transistor **Q8** therefore turns off. The supply of the clock **ICLK** to the memory **342** comes to a halt. Accordingly, in the memory **342** the signal **IDET,** which has been shifted sequentially, becomes fixed. In other words, data descriptive of the detected current from the reference block in this case is held in the form of parallel data in the memory **342.** Thereafter, if the value of the detected current falls below the value indicating a fatal defect such as a short due to bridging between wires, the parallel data are then supplied as SIGNALS **L1-L4** to the circuit **243.** Such arrangement makes it possible to use the value of the detected current from the reference block as a leakage current reference value.

A LOW may be provided as SIGNAL **RESET** at the time of again making a comparison between detected current and reference current. This again places the memory **342** in the operation start state and the supply of the clock **ICLK** can be started.

In accordance with the present modified version, a leakage current flowing in a circuit block that is estimated, when viewed in the light of circuit configuration, to be most likely to undergo the occurrence of leakage current, is really measured, and a leakage current flowing in a different circuit block is judged using such a measured value as a reference value. The use of such an actually-measured value makes it possible to perform tests without adopting an excessively severe reference value even when there is a change in the value of leakage current due to, for example, process fluctuation. The present modified version provides semiconductor integrated circuits that can be fabricated at stable yield rate.

The present modified version may be applied to a specified circuit block that is estimated, when viewed in the light of circuit configuration, to be highly susceptible to be influenced by leakage current. In such a case, if such a circuit block is judged to operate normally, it is possible to assume that the remaining other circuits also operate normally. This provides semiconductor integrated circuits that can be tested involving a less number of test steps.

As a candidate for measurement, that is, as a reference circuit block, either a circuit block on the same chip or a circuit block on a different chip may be used. For example, if a specific chip formed near a periphery of a wafer is estimated to be most likely to undergo the occurrence of leakage current, a circuit block formed in such a chip may be used as a reference circuit block.

Particularly, if one of circuit blocks in a different chip with the same structure as a test-target circuit block is selected as a reference circuit block, this makes it possible to more accurately perform testing because they are nearly identical in leakage current value with each other.

Additionally, as a reference circuit block, a circuit block lying adjacent to a test-target circuit block may be used. In other words, a circuit block that is considered to have been fabricated in fabrication conditions most similar to the fabrication conditions of a test-target circuit block, is used as a reference circuit block. This provides a semiconductor integrated circuit made up of circuit blocks having a more uniform leakage current distribution. Such arrangement is effective in, for example, fabricating semiconductor integrated circuits in ranks. Additionally, testing configuration can be simplified because a leakage current flowing in a test-target circuit block and another flowing in an adjacent circuit block are always compared with each other.

If a circuit block with a different configuration from a test-target circuit block is used, this may produce the problem that there occurs a difference in the value of leakage current between these two circuit blocks due to the configuration difference. In this case, arrangement may be made to perform a test by a threshold shift by the compare circuit **244** of FIGURE **3,** to prevent a normal leakage current value difference from being judged as fault.

In accordance with the present modified version , the supply of the clock **ICLK** to the memory **342** is cut off when the block test result **T** enters the HIGH state. The same arrangement may be applied to testing such as an IDDQ test. In other words, the FIG. 4 circuit structure may be used even when a fault is detected in the course of an IDDQ test on the FIG. 1 semiconductor integrated circuit. In this case, at the time when the block test result **T** enters the HIGH state, i.e., when a detected current from the reference circuit block exceeds the reference current, the shift operation of the scan register **210** of FIGURE **1** is stopped to abort the test. This eliminates the need to take time for testing after a fault is detected, therefore achieving reductions in the overall testing time.

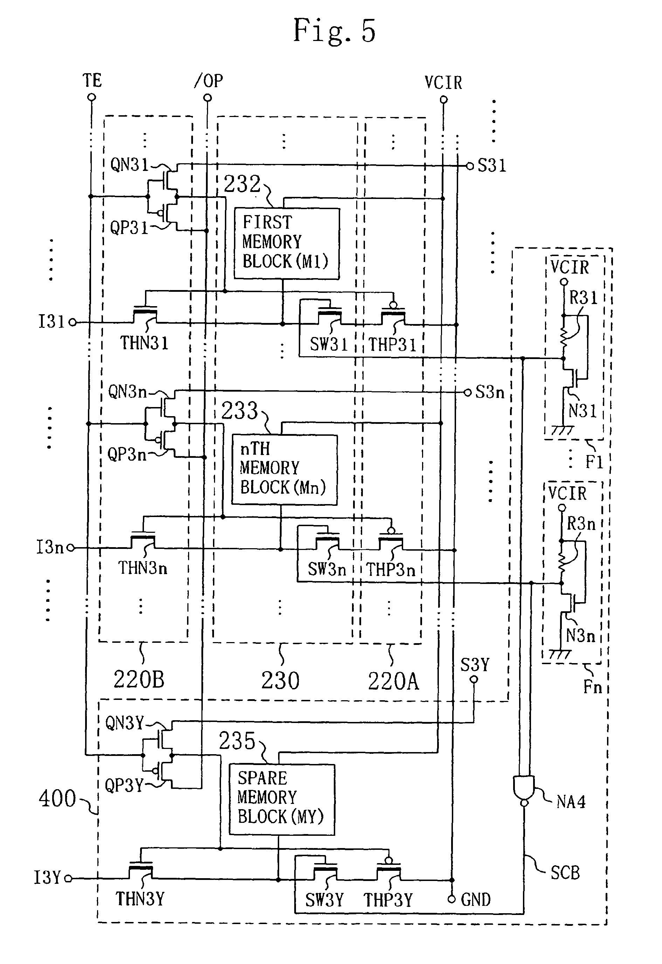

Referring now to FIGURE **5**, therein shown is another modified version of the semiconductor integrated circuit of the present invention. It is preferred that, even when the above-described test technique discovers that a semiconductor integrated circuit contains therein a faulty circuit block, such a faulty semiconductor integrated circuit can be restored to normal operation as a whole and be used as a product instead of discarding it. In the present modified version, a structure, shown in FIGURE **5**, is used to provide a semiconductor integrated circuit capable of being restored to normal operation even when it is judged to fail to operate normally. FIGURE **5** is a circuit diagram showing a part of a circuit as a result of addition of a spare block switch circuit to the FIG. 2 circuit. In the following description the same elements as shown in FIGURE **2** have been indicated by like reference numerals and the description thereof is not made.

A spare block switch circuit **400** of FIGURE **5** is a switch means for the switching of a faulty circuit block to a spare circuit block. The circuit **400** has a spare memory block **235**, a high-Vt PMOS transistor **THP3Y,** a high-Vt NMOS transistor **THN3Y,** a low-Vt NMOS transistor **QN3Y,** a low-Vt PMOS transistor **QP3Y,** a switch NMOS transistor **SW3Y,** fuse means **F1-Fn,** and a NAND circuit **NA4.**

The spare memory block **235** is a memory block to replace with a faulty memory block, having the same structure as each of the first to nth memory blocks **232-233** (**M1-Mn**). The transistors **THP3Y** and **THN3Y** are power supply line switch means. Entering the ON state, the transistor **THP3Y** secures a current path for the operation of the spare memory block **235.** Entering the ON state, the transistor **THN3Y** secures a current path for the test operation of the spare memory block **235.** The transistors **QN3Y** and **QP3Y** are drive elements for the switching of the transistors **THP3Y** and **THN3Y** according to the level of the test enable signal **TE.**

Each fuse means **F** (**F1-Fn**) is a circuit cutoff means made up of a fuse resistor **R** (**R31-R3n**) and an NMOS transistor **N** (**N31-N3n**). As the NMOS transistors **N31-N3n,** transistors having a small gate W/L ratio (i.e., high-resistance transistors in which little current flows) are employed. The NAND circuit **NA4** is a logical gate for providing, based on the output of each fuse means **F1-Fn,** a spare block switch signal **SCB** formed of a NAND logical signal. The transistor **SW3Y** is a switch means for the opening and closing of a current path for the operation of the spare memory block 235 according to the level of SIGNAL **SCB** received from the NAND circuit **NA4.**

Each of the memory blocks **M1-Mn,** which are identical in structure with the spare memory block **235**, is a memory block to electrically replace with the spare block **235** when it is determined as a faulty memory block. Connected between the node of the first memory block **232** and the transistor **THN31** and the transistor **THP31** is the transistor **SW31** with its gate coupled to the output of the fuse means F1. Likewise, connected between the node of the nth memory block **233** and the transistor **THN3n** and the transistor **THP3n** is the transistor **SW3n** with its gate coupled to the output of the fuse means **Fn.** The remaining other memory blocks are identical in circuit structure with the first and nth memory blocks. The gates of the transistors **SW31-SW3n** are coupled to the inputs of the NAND circuit **NA4** respectively.

Referring to FIGURE **5**, the memory block replacement operation of the spare block switch circuit **400** is now described below.

First, a situation, in which each memory block **M1-Mn** operates normally, is considered. In this case, no processing is performed on each fuse resistor **R31-R3n.** Accordingly, outputs from the fuse means **F1-Fn** will assume respective values produced by voltage division of **VCIR** by the transistors **N31-N3n** that are taken as high-resistance resistors and the fuse resistors **R31-R3n.** These outputs therefore are all fixed at a level very near to HIGH. As a result, all the transistors **SW31-SW3n** of the memory blocks **M1-Mn** are placed into the ON state, and the output of the NAND circuit **NA4,** i.e., SIGNAL **SCB,** becomes LOW thereby turning off the transistor **SW3Y** of the spare memory block **235.** As a result, current paths for the operation of the memory blocks **M1-Mn** are secured and a current path for the operation of the spare memory block **235** is cut off, whereupon each memory block enters the operation state to operate.

Next, a situation, in which the first memory block **232** is judged to be a faulty memory block, is considered. In this case, it is possible to specify a faulty circuit block from data in the reference current determination memory when the block test result **T** becomes HIGH. A fuse resistor regarding the first memory block **232**, i.e., the fuse resistor **R31,** is disconnected therefrom. Such disconnection of the fuse resistor **R31** may be carried out using techniques such as high-voltage application and laser which exert no influence on the other elements. As a result, the output of the fuse means **F1** is pulled down to **GND** by the transistor **N31** that is taken as a high-resistance resistor, being fixed at the level of LOW. The transistor **SW31** of the first memory block **232** then turns off. On the other hand, since the output of the fuse means **F1** becomes LOW (i.e., one input of the NAND circuit **NA4**), the NAND circuit **NA4** provides a HIGH as SIGNAL **SCB.** Because of this, the transistor **SW3Y** of the memory block **235** turns on. Whereas the current path for the operation of the first memory block **232** (i.e., the faulty memory block) is cut off, the current path for the operation of the spare memory block **235** is secured. As a result, the spare memory block **235** operates in place of the first memory block **232.**

In accordance with the present modified version, a memory block, found by testing to be faulty, is replaced by a spare memory block. This provides semiconductor integrated circuits capable of being restored to normal operation by such replacement.

The transistor **SW3Y** of the spare memory block **235** is controlled based on the output of the fuse means **F1-Fn,** using a NAND circuit. There is provided a single spare memory block for a plurality of regular memory blocks. When there is a faulty memory block in the regular memory blocks, such a faulty memory block is replaced by the spare memory block.

The description has been made in terms of memory blocks. However, for the case of different types of circuit blocks such as logical circuits, spare logical circuits may be disposed.

In the foregoing description, one spare circuit block is provided to n circuit blocks. Every circuit block may be provided with a respective spare circuit block. A plurality of spare circuit blocks may be disposed correspondingly to a plurality of circuit blocks. In the latter case, as the plurality of spare circuit blocks, identical circuit blocks may be provided. Spare circuit blocks of different types formed of circuit blocks, such as memory blocks, of the same type may be provided.

Further, circuit block replacement may be carried out whenever a HIGH (fault) is provided as the block test result **T** in testing each circuit block. Alternatively, batch circuit block replacement may be carried out in which circuit blocks that have caused application of a HIGH (fault) to the register circuit **250** are all replaced with spare circuit blocks at one time.

Additionally, it is designed such that only one or more circuit blocks that are highly susceptible to fail to operate normally are provided with corresponding spare circuit blocks.

High-Vt MOS transistors disposed to turn off circuit blocks of low-Vt MOS transistors at the standby mode of operation are used to select from among the circuit blocks a test-target circuit block. A circuit current flowing in the selected circuit block is detected. When the detected current exceeds the reference value, it is determined that such a selected circuit block fails to operate normally. As a result of such arrangement, the number of circuit blocks that are tested at one time is limited without newly providing additional switch means, whereupon testing such as IDDQ testing on circuits formed of low-Vt MOS transistors can be realized.

Further, a circuit block that fails to operate normally is replaced by a spare circuit block. This provides semiconductor integrated circuits that are not subjected to immediate discard even when there occurs a fault therein and that can be restored to normal operation, thereby enhancing production yield.

Leakage current is judged per circuit block, which makes it possible to easily specify, from among circuit blocks, a circuit block with a leakage current in excess of the reference value. This provides semiconductor integrated circuits capable of easy circuit block evaluation, fault analysis, and so on.

Arrangement may be made in which only the circuit block switch parts **220A** and **220B** and the test-target circuit **230** are provided on a chip and a specific pad is used to apply SIGNALS **S11-S61** from outside a wafer on which the chip is formed. Additionally, it is possible to examine the detected currents **I11-I61** from outside the wafer. This achieves testing such as IDDQ testing on circuits formed of low-Vt MOS transistors without involving increases in chip area.

In addition to the above, it is possible to test a plurality of circuit blocks at the same time by use of the block selection data **BS** of bits of which a plurality of desired bits are set at HIGH and by adequately setting a reference value. As a result of such arrangement, the number of times a circuit block test is carried out can be reduced, for it is sufficient that individual testing of the circuit blocks is carried out only when such simultaneous testing gives an indication of fault. Further, it becomes possible to perform testing on circuit blocks in the same situation that they are actually used.

In addition to the above, each circuit block may be provided with the test circuit **240** and the block test result **T** and parallel input may be applied to the register circuit **250.** This arrangement makes it possible to increase the number of circuit blocks that can be tested at the same time.

In the structure shown in FIGURE **3,** the reference current determination memory **242** has only one type of parallel data. Arrangement may be made in which a memory capable of storing a plurality of different items of parallel data is provided to select therebetween. Further, without formation of a memory on a chip, it is possible to provide parallel data to the circuit **243** from outside a wafer on which the chip is formed.

In the foregoing description, the ON state of the transistors **THP11-THP61** secures current paths used during the normal mode of operation and the ON state of the NMOS transistors **THN11-THN61** secures current paths used during the test mode of operation, the transistors **THP11-THP61** and **THN11-THN61** being disposed on the side towards which currents flow from the circuit blocks, and SIGNALS **TE** and **S** are positive logic; however, these are not considered restrictive. For example, in each circuit block a current path, through which **VCIR** is supplied, is provided with a high-Vt PMOS transistor in place of a transistor **THP** and with a high-Vt NMOS transistor in place of a transistor **THN** for switching between a circuit path used during the normal mode of operation and a circuit path used during the test mode of operation.

The structure of the present invention is used to establish disconnection from or connection to a power supply circuit and, in addition, to access a circuit block at the time of real use. When a semiconductor integrated circuit receives the address of a faulty circuit block at the time of real use, it is required that a spare circuit block is selected for the faulty circuit block. Suppose here that there exists a faulty circuit block. In such a case, with data indicative of the faulty circuit block retained in the register circuit **250**, the retained data and the decoded address of an access-target circuit block are compared. If an indication of agreement is given, this means that the access-target circuit block fails to operate normally. Therefore, arrangement in circuit structure may be made in advance in order that a spare circuit block may become a target for access in place of the faulty circuit block.

## Claims

1. A semiconductor integrated circuit comprising:
a test-target circuit (230), constructed of a plurality of circuit blocks (231-234) each including MOS transistors having a first threshold voltage, for being subjected to a test;
**characterised by**
power supply line switch means (THN11-THN61, THP11-THP61), disposed in a power supply line of each said circuit block and constructed of MOS transistors having a second threshold voltage in excess of said first threshold voltage, for switching the path of a current flowing in each said circuit block to a normal mode operation current path or to a test mode current path, whereas a circuit block which is connected to its test mode current path is cut off from its normal mode operation current path;
circuit block selection means (210) for selecting from among said plurality of circuit blocks a desired circuit block that is required to make a switch in current path to said test mode current path during the test mode of operation; and
test means (240) for generating, at the time when the value of a current flowing in said switched test mode current path in said selected circuit block exceeds a predetermined reference value, a specified signal (T) indicating that said selected circuit block fails to operate normally.

2. The semiconductor integrated circuit according to claim 1, wherein said test-target circuit (230) is constructed of a CMOS integrated circuit.

3. The semiconductor integrated circuit according to claim 1, wherein said circuit block selection means (210) includes a scan register for receiving a signal and sequentially shifting said received signal to generate a block selection signal used to select said desired circuit block.

4. The semiconductor integrated circuit according to claim 1, wherein said test means (240) includes reference value generation means (243) for generating the predetermined reference values corresponding to said plurality of circuit blocks respectively.

5. The semiconductor integrated circuit according to claim 4, wherein said test means (240) further includes:
voltage division means (R1 B,R2B; R1A,R2A) for receiving said current flowing in said switched current path in said desired circuit block and for dividing a reference voltage received in order to generate said reference value equal to the value of said received current; and
storage means (242) for holding necessary data in said reference voltage division.

6. The semiconductor integrated circuit according to claim 4, wherein said reference value generation means (243) includes means (RR1-RR4) for determining the accuracy of said reference values correspondingly to said plurality of circuit blocks respectively.

7. The semiconductor integrated circuit according to claim 4, wherein said reference value generation means (243) has power supply lines (VREF) for the generation of said reference values which are different from power supply lines (VCIR) for the supply of voltage to said plurality of circuit blocks(231-234).

8. The semiconductor integrated circuit according to claim 7 further comprising:
a terminal for supplying, from outside said semiconductor integrated circuit, voltage to said power supply lines for the supply of voltage to said plurality of circuit blocks; and
a terminal for supplying, from outside said semiconductor integrated circuit, voltage to said power supply lines for the generation of said reference values.

9. The semiconductor integrated circuit according to claim 1, wherein said test means (240) includes means for simultaneously testing a plurality of circuit blocks selected by said circuit block selection means (210) from among said plurality of circuit blocks (231-234).

10. The semiconductor integrated circuit according to claim 1 further comprising:
a spare circuit block(235) having the same circuit structure as at least one of said plurality of circuit blocks (231-234); and
switch means (SW31-SW3n) for replacing, when a specified signal (T) is generated indicating that a circuit block in said plurality of circuit blocks that has the same structure as said spare circuit block fails to operate normally, said faulty circuit block with said spare circuit block.

11. The semiconductor integrated circuit according to claim 1, wherein said test means (240) further includes stop means for stopping said test mode operation when a specified signal (T) is generated indicating that said selected circuit block fails to operate normally.

## Patentansprüche

1. Integrierte Halbleiterschaltung, die umfasst:
eine Testobjekt-Schaltung (230), die aus einer Vielzahl von Schaltungsblöcken (231-234) aufgebaut ist, die jeweils MOS-Transistoren mit einer ersten Schwellenspannung enthalten, und die einem Test unterzogen wird;
**gekennzeichnet durch**:
Stromzuführleitungs-Umschalteinrichtungen (THN-11-THN61, THP11-THP61), die in einer Stromzuführleitung jedes der Schaltungsblöcke angeordnet sind und aus MOS-Transistoren mit einer zweiten Schwellenspannung aufgebaut sind, die größer ist als die erste Schwellenspannung, um den Weg von Strom, der in jedem der Schaltungsblöcke fließt, auf einen Normalmodusbetrieb-Stromweg oder einen Testmodus-Stromweg zu schalten, während ein Schaltungsblock, der mit seinem Testmodus-Stromweg verbunden ist, von seinem Normalmodusbetrieb-Strom getrennt wird;
eine Schaltungsblock-Auswähleinrichtung (210) zum Auswählen eines gewünschten Schaltungsblocks aus der Vielzahl von Schaltungsblöcken, der während des Test-Betriebsmodus eine Umschaltung des Stromwegs auf den Testmodus-Stromweg ausführen muss; und
eine Testeinrichtung (240), die zu der Zeit, zu der der Wert eines Stroms, der auf dem umgeschalteten Testmodus-Stromweg in dem ausgewählten Schaltungsblock fließt, einen vorgegebenen Bezugswert übersteigt, ein spezifiziertes Signal (T) erzeugt, das anzeigt, dass der ausgewählte Schaltungsblock nicht normal arbeitet.

2. Integrierte Halbleiterschaltung nach Anspruch 1, wobei die Testobjekt-Schaltung (230) aus einer integrierten CMOS-Schaltung aufgebaut ist.

3. Integrierte Halbleiterschaltung nach Anspruch 1, wobei die Schaltungsblock-Auswähleinrichtung (210) ein Abtastregister zum Empfangen eines Signals und zum sequenziellen Verschieben des empfangenen Signals enthält, um ein Blockauswählsignal zu erzeugen, das verwendet wird, um den gewünschten Schaltungsblock auszuwählen.

4. Integriere Halbleiterschaltung nach Anspruch 1, wobei die Testeinrichtung (240) eine Bezugswert-Erzeugungseinrichtung (243) zum Erzeugen der vorgegebenen Bezugswerte enthält, die jeweils der Vielzahl von Schaltungsblöcken entsprechen.

5. Integrierte Halbleiterschaltung nach Anspruch 4, wobei die Testeinrichtung (240) des Weiteren enthält:
spannungsteileinrichtungen (R1B, R2B; R1A, R2A) zum Empfangen des Stroms, der auf dem umgeschalteten Stromweg in dem gewünschten Schaltungsblock fließt und zum Teilen einer empfangenen Bezugsspannung, um den Bezugswert zu erzeugen, der dem Wert des empfangenen Stroms gleich ist; und
eine Speichereinrichtung (242) zum Aufnehmen erforderlicher Daten bei der Bezugsspannungsteilung.

6. Integrierte Halbleiterschaltung nach Anspruch 4, wobei die Bezugswert-Erzeugungseinrichtung (243) Einrichtungen (RR1-RR4) zum Bestimmen der Genauigkeit der Bezugswerte jeweils entsprechend der Vielzahl von Schaltungsblöcken enthält.

7. Integrierte Halbleiterschaltung nach Anspruch 4, wobei die Bezugswert-Erzeugungseinrichtung (243) Energiezuführleitungen (VREF) für die Erzeugung der Bezugswerte aufweist, die sich von den Energiezuführleitungen (VCIR) zur Zufuhr von Spannung zu der Vielzahl von Schaltungsblöcken (231-234) unterscheiden.

8. Integrierte Halbleiterschaltung nach Anspruch 7, die des Weiteren umfasst:
einen Anschluss zum Zuführen von Spannung zu Energiezuführleitungen für die Zufuhr von Spannung zu der Vielzahl von Schaltungsblöcken von außerhalb der integrierten Halbleiterschaltung; und
einen Anschluss zum Zuführen von Spannung zu den Energiezuführleitungen für die Erzeugung der Bezugswerte von außerhalb der integrierten Halbleiterschaltung.

9. Integrierte Halbleiterschaltung nach Anspruch 1, wobei die Testeinrichtung (240) eine Einrichtung zum simultanen Testen einer Vielzahl von Schaltungsblöcken enthält, die durch die Schaltungsblock-Auswähleinrichtung (210) aus der Vielzahl von Schaltungsblöcken (231-234) ausgewählt werden.

10. Integrierte Halbleiterschaltung nach Anspruch 1, die des Weiteren umfasst:
einen Ersatz-Schaltungsblock (235), der die gleiche Schaltungsstruktur wie wenigstens einer der Vielzahl von Schaltungsblöcken (231-234) hat; und
Schalteinrichtungen (SW31-SW3n), die, wenn ein spezifiziertes Signal (T) erzeugt wird, das anzeigt, dass ein Schaltungsblock in der Vielzahl von Schaltungsblöcken, der die gleiche Struktur hat wie der Ersatz-Schaltungsblock, nicht normal arbeitet, den fehlerhaften Schaltungsblock durch den Ersatz-Schaltungsblock ersetzen.

11. Integrierte Halbleiterschaltung nach Anspruch 1, wobei die Testeinrichtung (240) des Weiteren eine Unterbrechungseinrichtung enthält, die den Testmodusbetrieb unterbricht, wenn ein spezifiziertes Signal (T) erzeugt wird, das anzeigt, dass der ausgewählte Schaltungsblock nicht normal arbeitet.

## Revendications

1. Circuit intégré à semiconducteur comprenant :
un circuit cible de test (230), constitué d'une pluralité de blocs de circuits (213-234) comprenant chacun des transistors de type MOS présentant une première tension de seuil, destiné à être soumis à un test,
**caractérisé par**
un moyen de commutation de ligne d'alimentation (THN11-THN61, THP11-THP61), disposé sur une ligne d'alimentation de chaque dit bloc de circuit et constitué de transistors de type MOS présentant une deuxième tension de seuil supérieure à ladite première tension de seuil, destiné à commuter le trajet d'un courant circulant dans chaque dit bloc de circuit sur un trajet de courant de fonctionnement en mode normal ou un trajet de courant en mode de test, alors qu'un bloc de circuit qui est connecté à son trajet de courant en mode de test est isolé de son trajet de courant de fonctionnement en mode normal,
un moyen de sélection de bloc de circuit (210) destiné à sélectionner parmi ladite pluralité de blocs de circuits un bloc de circuit souhaité qui est nécessaire pour effectuer une commutation de trajet de courant sur ledit trajet de courant en mode de test au cours du fonctionnement en mode de test, et
un moyen de test (240) destiné à générer, au moment où la valeur d'un courant circulant sur ledit trajet de courant en mode de test commuté dans ledit bloc de circuit dépasse une valeur de référence prédéterminée, un signal spécifié (T) indiquant que ledit bloc de circuit sélectionné ne fonctionne pas normalement.

2. Circuit intégré à semiconducteur selon la revendication 1, dans lequel ledit circuit cible de test (230) est constitué d'un circuit intégré de type CMOS.

3. Circuit intégré à semiconducteur selon la revendication 1, dans lequel ledit moyen de sélection de bloc de circuit (210) comprend un registre à décalage destiné à recevoir un signal et à décaler séquentiellement ledit signal reçu pour générer un signal de sélection de bloc utilisé pour sélectionner ledit bloc de circuit souhaité.

4. Circuit intégré à semiconducteur selon la revendication 1, dans lequel ledit moyen de test (240) comprend un moyen de génération de valeurs de référence (243) destiné à générer les valeurs de référence prédéterminées correspondant à ladite pluralité de blocs de circuits respectivement.

5. Circuit intégré à semiconducteur selon la revendication 4, dans lequel ledit moyen de test (240) comprend en outre :
un moyen de division de tension (R1B, R2B ; R1A, R2A) destiné à recevoir ledit courant circulant dans ledit trajet de courant commuté dans ledit bloc de circuit souhaité et destiné à diviser une tension de référence reçue afin de générer ladite valeur de référence de façon à ce qu'elle soit égale à la valeur dudit courant reçu, et
un moyen de mémorisation (242) destiné à conserver des données nécessaires dans ladite division de la tension de référence.

6. Circuit intégré à semiconducteur selon la revendication 4, dans lequel ledit moyen de génération de valeurs de référence (243) comprend un moyen (RR1-RR4) destiné à déterminer la précision desdites valeurs de référence en correspondance avec ladite pluralité de blocs de circuits respectivement.

7. Circuit intégré à semiconducteur selon la revendication 4, dans lequel ledit moyen de génération de valeurs de référence (243) comporte des lignes d'alimentation (VREF) destinées à la génération desdites valeurs de référence, lesquelles sont différentes des lignes d'alimentation (VCIR) destinées à fournir une tension à ladite pluralité de blocs de circuits (231-234).

8. Circuit intégré à semiconducteur selon la revendication 7 comprenant en outre :
une borne destinée à fournir, depuis l'extérieur dudit circuit intégré à semiconducteur, une tension auxdites lignes d'alimentation destinées à fournir une tension à ladite pluralité de blocs de circuits, et
une borne destinée à fournir, depuis l'extérieur dudit circuit intégré à semiconducteur, une tension auxdites lignes d'alimentation destinées à la génération desdites valeurs de référence.

9. Circuit intégré à semiconducteur selon la revendication 1, dans lequel ledit moyen de test (240) comprend un moyen destiné à tester simultanément une pluralité de blocs de circuits sélectionnés par ledit moyen de sélection de bloc de circuit (210) parmi ladite pluralité de blocs de circuits (321-234).

10. Circuit intégré à semiconducteur selon la revendication 1 comprenant en outre :
un bloc de circuit de rechange (235) ayant la même structure de circuit qu'au moins l'un de ladite pluralité de blocs de circuits (231-234), et
un moyen de commutation (SW31-SW3n) destiné à remplacer, lorsqu'un signal spécifié (T) est généré pour indiquer qu'un bloc de circuit dans ladite pluralité de blocs de circuits qui a la même structure que ledit bloc de circuit de rechange ne fonctionne pas normalement, ledit bloc de circuit défectueux par ledit bloc de circuit de rechange.

11. Circuit intégré à semiconducteur selon la revendication 1, dans lequel ledit moyen de test (240) comprend en outre un moyen d'arrêt destiné à mettre fin audit fonctionnement en mode de test lorsqu'un signal spécifié (T) est généré pour indiquer que ledit bloc de circuit sélectionné ne fonctionne pas normalement.
